(19) Europäisches Patentamt
European Patent Office
Office européen des brevets

(11) EP 2 412 450 A1

(12) # EUROPEAN PATENT APPLICATION
published in accordance with Art. 153(4) EPC

(43) Date of publication:
**01.02.2012 Bulletin 2012/05**

(21) Application number: **10756275.3**

(22) Date of filing: **24.03.2010**

(51) Int Cl.:
***B05D 1/26** (2006.01)* ***H01L 51/50** (2006.01)*
***H05B 33/10** (2006.01)*

(86) International application number:
**PCT/JP2010/055779**

(87) International publication number:
**WO 2010/110481 (30.09.2010 Gazette 2010/39)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **25.03.2009 JP 2009073712**

(71) Applicant: **Sumitomo Chemical Company, Limited**
**Tokyo 104-8260 (JP)**

(72) Inventors:
- **KAIHO, Akio**
  **Tsukuba-shi**
  **Ibaraki 305-0821 (JP)**
- **SEIKE, Takahiro**
  **Tsukuba-shi**
  **Ibaraki 305-0005 (JP)**

(74) Representative: **Jackson, Martin Peter**
**J.A. Kemp & Co.**
**14 South Square**
**Gray's Inn**
**GB-London WC1R 5JJ (GB)**

(54) **COATING METHOD AND PRODUCTION METHOD FOR ORGANIC ELECTROLUMINESCENT ELEMENT**

(57) A method for coating a body with a coating liquid, the body being arranged above a nozzle through which the coating liquid is to be discharged upwardly, the coating method comprising:
a coating step in which the nozzle and the body are relatively moved in a prescribed coating direction while the body is kept in contact with the coating liquid discharged through the nozzle; and
a non-coating step in which the nozzle and the body are relatively moved to the coating direction while the body is kept detached from the coating liquid, wherein
the two steps of coating and non-coating are alternately repeated, using the nozzle, which has a plurality of slit-shape outlets.

FIG.7

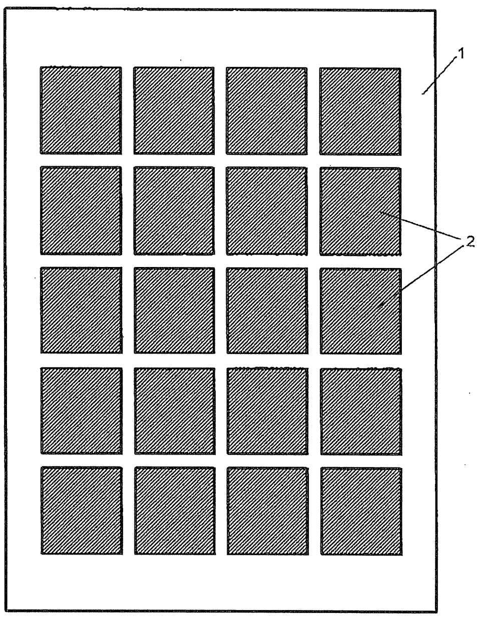


EP 2 412 450 A1

## Description

### TECHNICAL FIELD

The present invention relates to a method for coating a body to with a coating liquid and a method for manufacturing an organic electroluminescent element and an organic photovoltaic cell by the coating method.

### BACKGROUND ART

Organic electroluminescent elements (hereinafter, also referred to as organic EL elements) in which the light-emitting portions are made of organic substances are one of elements emitting light with voltage applied thereto. An organic EL element comprises a pair of electrodes and at least one organic layer placed between the electrodes and is generally formed by stacking components in sequence. The organic EL element comprises at least a light-emitting layer as the organic layer and emits light by combining holes and electrons that are injected with voltage applied thereto in the light-emitting layer.

The use of coating methods has been studied as a method for forming the organic layer in view of easiness of steps. In the use of coating methods, coating films are formed by applying coating liquids comprising organic materials to be organic layers by prescribed coating methods and are further dried to form organic layers. Inkjet printing methods, spin coating methods, capillary coating methods, and other methods are known as such coating methods.

Coating methods used for forming large organic EL elements used in illumination devices and the like need to be coating methods capable of efficiently applying coating films having a uniform film thickness over a wide range. A capillary coating method is suitable for the coating methods satisfying this requirement in view of coating liquid use efficiency and upsizing of elements (for example, see JP 2004-164873 A).

### DISCLOSURE OF INVENTION

Although a coating film having a uniform film thickness can be efficiently applied over a wide range by the use of a capillary coating method, pattern coating is not easily performed by a general capillary coating method. Fig. 7 is a plane schematic of a body 1. In Fig. 7, hatching is drawn at a portion 2 in a pattern on the body 1. Fig. 7 illustrates an example in which a plurality of rectangular areas arranged at prescribed intervals in both row direction and column direction are coated in a pattern. These areas are extremely large. A coating liquid is not easily applied in a pattern by a conventional capillary coating method. Therefore, generally, the whole surface of the body 1 is coated with the coating liquid, and then, the coating liquid applied to an undesired portion is removed to coat only a prescribed area on the body 1 with the coating liquid in a pattern. A method for removing the coating liquid may be a method for physically wiping off (peeling off), a laser ablation or the like.

Thus, the conventional coating method requires a step of removing a coating liquid applied to an undesired portion, and therefore, the number of steps increases, the coating liquid use efficiency decreases, and as a result, manufacturing cost increases. Moreover, undesired foreign matters may mix into a coating film at a step of removing the coating liquid to decrease the reliability of manufactured elements. Accordingly, a coating method is required that does not require the step of removing a coating solution and that is capable of efficiently coating a large area.

An object of the present invention is to provide a coating method capable of coating a large area in a pattern.

The present invention relates to a method for coating a body with a coating liquid, the body being arranged above a nozzle through which the coating liquid is to be discharged upwardly, the coating method comprising:

a coating step in which the nozzle and the body are relatively moved in a prescribed coating direction while the body is kept in contact with the coating liquid discharged through the nozzle; and
a non-coating step in which the nozzle and the body are relatively moved to the coating direction while the body is kept detached from the coating liquid, wherein
the two steps of coating and non-coating are alternately repeated, using the nozzle, which has a plurality of slit-shape outlets.

The present invention relates to the method, wherein the nozzle comprises a shim specifying the width of the slit-shape outlets in the shorter-side direction of the outlets, and
the shim is provided in a region except the slit-shape outlets and has a non-liquid feeding portion.

The present invention relates to a method for manufacturing an organic electroluminescent element comprising one or more organic layers, the method comprising: coating a body in a pattern with a coating liquid comprising an organic material by the coating method and drying the liquid to form the one or more organic layers.

The present invention relates to a lighting device’ comprising an organic electroluminescent element manufactured by the manufacturing method.

The present invention relates to a planar light source comprising an organic electroluminescent element manufactured by the manufacturing method.

The present invention relates to a method for manufacturing an organic photovoltaic cell comprising one or more organic layers, the method comprising: coating a body in a pattern with a coating liquid comprising an organic material by the coating method, and drying the liquid to form the one or more organic layers.

The present invention relates to a solar photovoltaic module comprising an organic photovoltaic cell manufactured by the manufacturing method.

The present invention relates to an organic optical sensor comprising an organic photovoltaic cell manufactured by the manufacturing method.

## BRIEF DESCRIPTION OF DRAWINGS

Fig. 1 is a schematic of a cap coater system 11 used for forming a light-emitting layer.
Fig. 2 is a side view of a nozzle 13.
Fig. 3 is a top view of the nozzle 13.
Fig. 4 is a sectional schematic viewed from a sectional line IV-IV in Fig. 2.
Fig. 5 is a sectional schematic viewed from a sectional line V-V in Fig. 2.
Fig. 6 is a sectional schematic viewed from a sectional line VI-VI in Fig. 3.
Fig. 7 is a plane schematic of a body 1.

## EXPLANATIONS OF LETTERS OR NUMERALS

| | |
|---|---|
| 1 | body |
| 2 | portion in a pattern |
| 11 | cap coater system |
| 12 | table |
| 13 | nozzle |
| 14 | tank |
| 16 | coating liquid feed pipe |
| 17 | coating liquid |
| 18 | liquid level sensor |
| 19 | body |
| 21 | shim |
| 21a | plate body |
| 21b | coating liquid guiding portion |
| 22 | holding body |
| 23 | slit-shape outlets |
| 24 | manifold |
| X | coating direction |
| Y | width direction |
| Z | vertical direction |

## Description of Embodiments

A coating method for an embodiment of the present invention is a method for coating a body with the coating liquid, wherein the body is arranged above a nozzle which discharges a coating liquid upwardly. The coating method comprises: a coating step of relatively moving the nozzle and the body to a prescribed coating direction while the body is wetted with the coating liquid discharged through the nozzle; and a non-coating step of relatively moving the nozzle and the body to the coating direction while the body is kept detached from the coating liquid. Two steps of the coating and the non-coating are alternately repeated, using the nozzle having a plurality of slit-shape outlets. In the present specification, "the body is kept in contact with the coating liquid" means a state where the coating liquid adheres to the body.

The coating method of the present embodiment is described below through the description of the formation of a light-emitting layer of an organic EL element. An organic EL element of the present embodiment comprises a pair of

electrodes and at least one organic layer interposed between the electrodes and is formed by stacking these on a substrate. The organic EL element comprises at least a light-emitting layer as the one or more organic layers.

A method for discharging the coating liquid upwardly from the nozzle may be a method for utilizing capillary force, a method for utilizing capillary force and static pressure, a method for utilizing static pressure, or a method for using a pump. A capillary coating method in which the coating liquid is discharged upwardly utilizing capillary force and static pressure to apply the coating liquid is described in the description below.

Fig. 1 is a schematic of a cap coater system 11 used for forming a light-emitting layer. An example of a method for manufacturing an organic EL element formed of "anode/light-emitting layer/cathode" is described below (where a symbol "forward slash (/)" indicates that the layers across the symbol "/" are adjacently stacked. The same shall apply hereinafter.) For example, a light-emitting layer is formed into a film at a substrate (hereinafter, also referred to as a body) with an anode formed thereon in an organic EL element having an element structure in which the anode, the light-emitting layer, and a cathode are stacked on the substrate in this order. Hereinafter, "upward" and "downward" in the present specification mean "upward in the vertical direction" and "downward in the vertical direction, respectively. In the description of the cap coater system 11 below, the structure of a nozzle 13 and the like is based on a structure in an arrangement when the coating liquid is applied.

The cap coater system 11 mainly comprises a table 12, the nozzle 13, and a tank 14. The table 12 holds a body 19 so as to be placed on the downward of its main surface. A method for holding the body 19 may be vacuum adsorption. The table 12 reciprocates in a horizontal direction by using a displacement driving unit (not illustrated) such as an electric motor and a hydraulic equipment. Hereinafter, a movement direction of the table 12 is also referred to as a coating direction X.

The nozzle 13 comprises a plurality of (four in the present embodiment) slit-shape outlets from which the coating liquid is discharged. Fig. 2 is a side view of the nozzle 13. Fig. 3 is a top view of the nozzle 13. Fig. 4 is a sectional schematic viewed from a sectional line IV-IV in Fig. 2. Fig. 5 is a sectional schematic viewed from a sectional line V-V in Fig. 2. Fig. 6 is a sectional schematic viewed from a sectional line VI-VI in Fig. 3.

As illustrated in Figs. 2 and 3, the nozzle 13 is approximately plate-shape and mainly comprises a shim 21 and a pair of holding bodies 22 with the shim 21 interposed therebetween. The shim 21 functions as a spacer for the holding bodies 22. The interval between the pair of the holding bodies 22 is specified with the thickness of the interposed shim 21. The width of a slit-shape outlets 23 in the shorter-side direction (corresponds to the coating direction X in the present embodiment) is specified with the interval between the pair of the holding bodies 22 and thus is specified with the thickness of the shim 21 specifying this interval. Capillarity is utilized in the present embodiment, and therefore, the width of the slit-shape outlets 23 in the shorter-side direction is set as appropriate depending on the properties of the coating liquid, the thickness of the coating film, and the like and is generally about 0.01 millimeter to 1 millimeter. This width can be adjusted by changing the thickness of the shim 21.

A columnar concave portion having a semicircle at the bottom is formed in each of the pair of the holding bodies 22, and when the holding bodies are laminated, the two concave portions form a cylindrical cavity extending in a width direction Y. The width direction Y means a direction perpendicular to the coating direction X and a vertical direction Z. The axial center of the cavity corresponds to the laminated surface. The cavity composed of the two concave portions functions as a manifold 24 when the pair of the holding bodies 22 is laminated with the shim 21 interposed therebetween.

The longitudinal direction of slit-shape outlets 23 corresponds to the width direction Y (direction perpendicular to the coating direction X and the vertical direction Z), and the slit-shape outlets 23 are arranged at prescribed intervals in the width direction Y. Each of the slit-shape outlets 23 is formed from the top of the nozzle 13 to the manifold 24 and is connected to the manifold 24. The coating liquid fills the manifold 24 and is supplied from the manifold 24 to each slit-shape outlets 23. The width of the slit-shape outlet 23 in the longitudinal direction (width direction Y) is set to the width of a coating film in the width direction Y and is for example, 10 millimeters to 300 millimeters. The width of the coating film in the width direction Y may not completely correspond to the width of the slit-shape outlet 23 in the longitudinal direction (width direction Y). Therefore, the width of the slit-shape outlet 23 in the longitudinal direction (width direction Y) may not completely correspond to the width of the coating film in the width direction Y.

As described above, the shorter-side direction of the slit-shape outlets 23 is defined by the thickness of the shim 21. In the present embodiment, not only the width in the shorter-side direction (coating direction X) but also the width of the slit-shape outlets 23 in the longitudinal direction (width direction Y) is defined by the shim 21. The shim 21 of the present embodiment comprises a plate body 21a extending in the width direction Y below the manifold 24, and a non-liquid feeding portion 21b provided in a region except for a region (liquid feeding portion) provided with the slit-shape outlets 23. The plate body 21a and the non-liquid feeding portion 21b are integrally formed in the present embodiment. Hereinafter, the "region provided with the slit-shape outlets 23" is also referred to as a liquid feeding portion. The non-liquid feeding portion 21b is formed of a plurality of-plate members upwardly extending from the plate body 21a in the region except for the region provided with the slit-shape outlets 23. The movement of the coating liquid from the manifold is prevented by the non-liquid feeding portion 21b, and thus, the coating liquid is not discharged in the region provided with the non-liquid feeding portion 21b. On the other hand, a void (slit-shape outlets 23) connected to the manifold 24

is formed in the region interposed between non-liquid feeding portions 21b, and thus, the coating liquid filling the manifold 24 is upwardly discharged through the slit-shape outlets 23. In such a manner, the coating liquid is selectively discharged from each slit-shape outlets 23 provided in the nozzle 13 at prescribed intervals in the width direction Y.

With the use of the shim 21 having the non-liquid feeding portion 21b, the shim 21 generally used for defining the width of the slit-shape outlets 23 in the shorter-side direction can be used as a member defining also the width of the slit-shape outlets 23 in the longitudinal direction. Therefore, there is no need to additionally provide a member defining the width of the slit-shape outlets 23 in the longitudinal direction to simplify the device structure. To define the width of the slit-shape outlets 23 in the longitudinal direction, a certain member may be arranged so as not to discharge the coating liquid from a portion except for the slit-shape outlets 23. A member except for the shim may also be used in such a member in another embodiment.

The width of the slit-shape outlets 23 in the shorter-side direction can be readily adjusted by exchanging the shim 21, and therefore, the nozzle 13 preferably comprises the shim 21. However, without using the shim 21, the-pair of the holding bodies 22 and the shim 21 are integrally formed.

The nozzle 13 is movably supported in the vertical direction Z and is moved in the vertical direction Z by a displacement driving unit such as an electric motor and a hydraulic equipment.

The tank 14 comprises a coating liquid 17. The coating liquid 17 contained in the tank 14 is the coating liquid 17 to be applied to the body 19 and is a liquid comprising an organic material to be a light-emitting layer in the present embodiment. Specifically, the coating liquid 17 is a solution in which a light-emitting material to be described later is dissolved in a solvent. The manifold 24 of the nozzle 13 and the tank 14 are connected via a coating liquid feed pipe 16. That is, the coating liquid 17 contained in the tank 14 is supplied into the manifold 24 through the coating liquid feed pipe 16 and is further applied to the body 19 through the slit-shape outlets 23. The tank 14 is movably supported in the vertical direction Z and is moved in the vertical direction Z by a displacement driving unit such as an electric motor and a hydraulic equipment. The tank 14 further comprises a liquid level sensor 18 detecting the liquid level of the coating liquid 17. The liquid level sensor 18 detects the height of the liquid level of the coating liquid 17 in the vertical direction Z. The liquid level sensor 18 is composed of, for example, an optical sensor and an ultrasonic vibration sensor.

The coating liquid 17 supplied from the tank 14 to the slit-shape outlets 23 through the coating liquid feed pipe 16 is extruded from the slit-shape outlets 23 by pressure (static pressure) generated according to the height of the liquid level in the tank 1-4. and force due to capillarity generated at the slit-shape outlets 23. Accordingly, the amount of the coating liquid extruded from the slit-shape outlets 23 can be controlled by controlling the relative difference between a liquid level position in the tank 14 determined by adjusting the vertical position of the tank 14 and a liquid level position in the nozzle 13.

The manifold 24 is connected to all of the slit-shape outlets 23, and therefore, the liquid level of the coating liquid in all of the slit-shape outlets 23 can be simultaneously controlled by controlling the liquid level in the tank 14.

The cap coater system 11 further comprises a controller created with a microcomputer and the like, and the controller controls the displacement driving unit as mentioned above and the like. The controller controls the displacement driving unit to control the positions of the nozzle 13 and the tank 14 in the vertical direction Z and displacement of the table 12 in the coating direction X. The coating liquid 17 is applied and is consumed, and as a result, the liquid level of the coating liquid 17 in the tank 14 decreases with time. However, the controller controls the displacement driving unit based on a result detected by the liquid level sensor 18 to adjust the position of the tank 14 in the vertical direction Z, and thus, the height of the coating liquid 17 to be extruded from the slit-shape outlets 23 can be controlled.

The motion of the cap coater system 11 as described above to apply the coating liquid will be described. Rectangular regions arranged in a matrix (five rows and four columns) as illustrated in Fig. 7 can be coated in a pattern by the use of the nozzle 13 comprising the four slit-shape outlets 23 as illustrated in Fig. 2.

The cap coater system 11 repeats the coating step and the non-coating step to apply the coating liquid in a pattern.

(Coating step)

The nozzle 13 and the body 19 are relatively moved in the prescribed coating direction X while the body 19 is kept in contact with the coating liquid discharged through the nozzle 13.

Specifically, the body 19 is kept in contact with the coating liquid by elevating the tank 14 so that the liquid level of the coating liquid contained in the tank 14 becomes higher than the top of the nozzle 13 to make the coating liquid be discharged from the slit-shape outlets 23 and by making the nozzle 13 arranged below the body 19 be in close contact with the body 19.

After the body 19 is kept in contact with the coating liquid, while the body is kept to be come in contact with the coating liquid, the nozzle 13 is lowered so that the nozzle 13 and the body 19 are spaced at an intended space, and the tank 14 is lowered so that the liquid level of the coating liquid contained in the tank 14 is lower than the top of the nozzle 13. The space between the body 19 and the nozzle 13 in this state is set at, for example, about 0.05 millimeter to 0.3

millimeter.

Subsequently, the body 19 is moved to one side (right side in Fig. 1) in the coating direction X. Four coating films in stripe shapes are formed by this movement. Although the body 19 is moved in the present embodiment, the nozzle 13 may also be moved to the other side (left side in Fig. 1) in the coating direction X, and both the nozzle 13 and the body 19 may also be moved. After the body 19 is moved for a prescribed distance, the movement of the body 19 is stopped.

(Non-coating step)

The nozzle 13 and the body 19 are relatively moved in the coating direction while the coating liquid is off from the body 19.

Specifically, both the nozzle 13 and the tank 14 are lowered. The coating liquid is off from the body 19 by this action. The coating liquid is discharged from the slit-shape outlets 23 due to surface tension while the body 19 is come in contact with the coating liquid. However, the liquid level of the coating liquid contained in the tank 14 is lower than the top of the nozzle 13 while the coating liquid is off from the body 19, and thus, the coating liquid is pulled back inside the slit-shape outlets 23.

Subsequently, the body 19 is moved for a prescribed distance to one side (right side in Fig. 1) in the coating direction X while the coating liquid is off from the body 19. In this step, the body 19 is not coated with the coating liquid because the coating liquid is off from the body 19.

The coating liquid can be applied in a pattern both in the coating direction X and the width direction Y by repeating the coating step and the non-coating step as described above, and as a result, two-dimensional pattern coating can be performed. Thus, the coating liquid can be prevented from coating an undesired portion, and therefore, a step of removing the coating liquid applied to the undesired portion can be omitted.

The coating liquid comprises a material (organic material to be a light-emitting layer in the present embodiment) to be a layer to be formed and a solvent.

A solvent having a prescribed boiling point may be used alone or in combination of a plurality of types for the solvent of the coating liquid. The solvent constituting the coating liquid of the present invention is desirably a solvent dissolving a material (organic material to be a light-emitting layer in the present embodiment) to be a layer to be formed, and such a solvent is exemplified below. Examples of the solvent constituting the coating liquid may include: aliphatic chlorine solvents such as chloroform (boiling point: 61 degrees Celsius), methylene chloride (boiling point: 40 degrees Celsius), 1,1-dichloroethane (boiling point: 57 degrees Celsius), 1,2-dichloroethane (boiling point: 83 degrees Celsius), 1,1,1-trichloroethane (boiling point: 74 degrees Celsius), and 1,1,2-trichloroethane (boiling point: 113 degrees Celsius; aromatic chlorine solvents such as chlorobenzene (boiling point: 132 degrees Celsius), o-dichlorobenzene (boiling point: 180 degrees Celsius), m-dichlorobenzene (boiling point: 173 degrees Celsius), and p-dichlorobenzene (boiling point: 174 degrees Celsius); aliphatic ether solvents such as tetrahydrofuran (boiling point: 66 degrees Celsius) and 1,4-dioxane (boiling point: 101 degrees Celsius); aromatic ether solvents such as anisole (boiling point: 154 degrees Celsius) and ethoxybenzene (boiling point: 170 degrees Celsius); aromatic hydrocarbon solvents such as toluene (boiling point: 111 degrees Celsius), o-xylene (boiling point: 144 degrees Celsius), m-xylene (boiling point: 139 degrees Celsius), p-xylene (boiling point: 138 degrees Celsius), ethylbenzene (boiling point: 136 degrees Celsius), p-diethylbenzene (boiling point: 184 degrees Celsius), mesitylene (boiling point: 211 degrees Celsius), n-propylbenzene (boiling point: 159 degrees Celsius), isopropylbenzene (boiling point: 152 degrees Celsius), n-butylbenzene (boiling point: 183 degrees Celsius), isobutylbenzene (boiling point: 173 degrees Celsius), s-butylbenzene (boiling point: 173 degrees Celsius), tetralin (boiling point: 208 degrees Celsius), and cyclohexylbenzene (boiling point: 235 degrees Celsius, measured at 737 mmHg); aliphatic hydrocarbon solvents such as cyclohexane (boiling point: 81 degrees Celsius), methylcyclohexane (boiling point: 101 degrees Celsius), n-pentane (boiling point: 36 degrees Celsius), n-hexane (boiling point: 69 degrees Celsius), n-heptane (boiling point: 98 degrees Celsius), n-octane (boiling point: 126 degrees Celsius), n-nonane (boiling point: 151 degrees Celsius), n-decane (boiling point: 174 degrees Celsius), decalin (the cis form has a boiling point of 196 degrees Celsius, and the trans form has a boiling point of 187 degrees Celsius), and bicyclohexyl (boiling point: 217 degrees Celsius to 233 degrees Celsius); aliphatic ketone solvents such as acetone (boiling point: 56 degrees Celsius), methyl ethyl ketone (boiling point; 80 degrees Celsius), methyl isobutyl ketone (boiling point: 117 degrees Celsius), cyclohexanone (boiling point: 156 degrees Celsius), 2-heptanone (boiling point: 150 degrees Celsius), 3-heptanone (boiling point: 147 degrees Celsius, measured at 765 mmHg), 4-heptanone (boiling point: 144 degrees Celsius), 2-octanone (boiling point: 174 degrees Celsius), 2-nonanone (boiling point: 195 degrees Celsius), and 2-decanone (boiling point: 209 degrees Celsius); aromatic ketone solvents such as acetophenone (boiling point: 202 degrees Celsius); aliphatic ester solvents such as ethyl acetate (boiling point: 77 degrees Celsius) and butyl acetate (boiling point: 120 degrees Celsius to 125 degrees Celsius); aromatic ester solvents such as methyl benzoate (boiling point: 200 degrees Celsius), butyl benzoate (boiling point: 213 degrees Celsius), and phenyl acetate (boiling point: 196 degrees Celsius); aliphatic polyhydric alcohol solvents and solvents of derivatives of aliphatic polyhydric alcohol such as ethylene glycol

(boiling point: 198 degrees Celsius), ethylene glycol monobutyl ether (boiling point: 171 degrees Celsius), ethylene glycol monoethyl ether (boiling point: 135 degrees Celsius), ethylene glycol monomethyl ether (boiling point: 125 degrees Celsius), 1,2-dimethoxyethane (boiling point: 85 degrees Celsius), propylene glycol (boiling point: 188 degrees Celsius), 1,2-diethoxymethane (boiling point: 124 degrees Celsius), triethylene glycol diethyl ether (boiling point: 222 degrees Celsius), and 2,5-hexanediol (boiling point: 218 degrees Celsius); aliphatic alcohol solvents such as methanol (boiling point: 65 degrees Celsius), ethanol (boiling point: 78 degrees Celsius), propanol (boiling point: 97 degrees Celsius), isopropanol (boiling point: 82 degrees Celsius), and cyclohexanol (boiling point: 161 degrees Celsius); aliphatic sulfoxide solvents such as dimethyl sulfoxide (boiling point: 37 degrees Celsius); and aliphatic amide solvents such as N-methyl-2-pyrrolidone (boiling point: 202 degrees Celsius) and N,N-dimethylformamide (boiling point: 153 degrees Celsius).

Among them, preferred are toluene, xylene, ethylbenzene, isopropylbenzene, anisole, mesitylene, n-butylbenzene, isobutylbenzene, cyclohexylbenzene, and tetralin. The coating liquid preferably comprises 50% by weight or larger of a solvent having a boiling point of 170 degrees Celsius or lower relative to the coating liquid.

The applied coating film is dried to allow pattern formation of a light-emitting layer. A cathode is formed on the light-emitting layer to allow formation of an organic EL element.

Although the organic EL element having a structure of "anode/light-emitting layer/cathode" is described above, the organic EL element is not limited to this structure. The layer structures, composition of each layer, and method for manufacturing each layer of organic EL elements are described below.

An organic EL element comprises a pair of electrodes (anode and cathode) and at least one organic layer that is interposed between the electrodes and that comprises at least one light-emitting layer. Between the anode and the cathode, not only the light-emitting layer but also an organic layer different from the light-emitting layer may also be provided, and further, an inorganic layer may be provided. The layers provided between the anode and the cathode is described below. Among them, a layer comprising organic substances corresponds to the organic layer. When the organic layer can be formed by a coating method, the layer is preferably formed by the coating method described as the method for forming the light-emitting layer. Although the organic substances constituting the organic layer may be low molecular compounds or macromolecular compounds, macromolecular compounds are preferable from the viewpoint of solubility in solvents and preferably have a number average' molecular weight of $10^3$ to $10^8$ in terms of polystyrene.

The layers provided between the cathode and the light-emitting layer may be an electron injection layer, an electron transport layer, or a hole block layer. When both the electron injection layer and the electron transport layer are provided between the cathode and the light-emitting layer, a layer closer to the cathode is called the electron injection layer, and a layer closer to the light-emitting layer is called the electron transport layer.

The electron injection layer is a layer having function to improve electron injection efficiency from the cathode. The electron transport layer is a layer having function to improve electron injection from the cathode, the electron injection layer, or the electron transport layer closer to the cathode. The hole block layer is a layer having function to block the transport of holes. When any one of the electron injection layer and the electron transport layer or both has function to block the transport of holes, the layer may also serve as the hole block layer.

The function of the hole block layer to block the transport of holes can be confirmed by, for example, manufacturing an element in which only hole current flows and confirming an effect of blocking holes through the reduction of the current value.

The layers provided between the anode and the light-emitting layer may be a hole injection layer, a hole transport layer, or an electron block layer. When both of the hole injection layer and the hole transport layer are provided, a layer closer to the anode is called the hole injection layer, and a layer closer to the light-emitting layer is called the hole transport layer.

The hole injection layer is a layer having function to improve hole injection efficiency from the anode. The hole transport layer is a layer having function to improve hole injection from the anode, the hole injection layer, or the hole transport layer closer to the anode. The electron block layer is a layer having function to block the transport of electrons. When any one of the hole injection layer and the hole transport layer or both has function to block the transport of electrons, the layer may also serve as the electron block layer.

The function of the electron block layer to block the transport of electrons can be confirmed by, for example, manufacturing an element in which only electron current flows and confirming an effect of blocking electrons through the reduction of the current value.

The electron injection layer and the hole injection layer may be collectively called charge injection layers, and the electron transport layer and the hole transport layer may be collectively called charge transport layers.

Examples of element structures applicable to the organic EL element of the present embodiment are described below.

a) anode/light-emitting layer/cathode
b) anode/hole injection layer/light-emitting layer/cathode
c) anode/hole injection layer/light-emitting layer/electron injection layer/cathode

d) anode/hole injection layer/light-emitting layer/electron transport layer/cathode
e) anode/hole injection layer/light-emitting layer/electron transport layer/electron injection layer/cathode
f) anode/hole transport layer/light-emitting layer/cathode
g) anode/hole transport layer/light-emitting layer/electron injection layer/cathode
h) anode/hole transport layer/light-emitting layer/electron transport layer/cathode
i) anode/hole transport layer/light-emitting layer/electron transport layer/electron injection layer/cathode
j) anode/hole injection layer/hole transport layer/light-emitting layer/cathode
k) anode/hole injection layer/hole transport layer/light-emitting layer/electron injection layer/cathode
l) anode/hole injection layer/hole transport layer/light-emitting layer/electron transport layer/cathode
m) anode/hole injection layer/hole transport layer/light-emitting layer/electron transport layer/electron injection layer/cathode
n) anode/light-emitting layer/electron injection layer/cathode
o) anode/light-emitting layer/electron transport layer/cathode
p) anode/light-emitting layer/electron transport layer/electron injection layer/cathode

The organic EL element of the present embodiment may comprise two or more light-emitting layers or may be a multiphoton type element.
The organic EL element may be covered by a sealing member such as a sealing film or a sealing plate for sealing. When the organic EL element is provided at the substrate, generally, the anode is arranged near the substrate, but the cathode may also be arranged near the cathode.
The (organic EL element of the present embodiment may further comprise an insulating layer that has a film thickness of 2 nanometers or smaller and that is provided adjacently to an electrode in order to improve adhesion with the electrode and charge injection properties from the electrode. A thin buffer layer may also be inserted between the layers described above to improve adhesion at the interface, to prevent mixing, and the like.
The order or the number of the layers to be stacked and the thickness of each of the layers can be appropriately set in consideration of light-emitting efficiency or element life.
The material of and the forming method of each layer constituting the organic EL element are described more specifically below.

<Substrate>

A substrate that is not chemically deformed at a step of manufacturing the organic EL element is suitably used for the substrate. For example, glass, plastic, silicon substrates, and stacked bodies thereof are used. The substrate is commercially available or can be manufactured by a publicly known method. A thin film transistor (TFT) substrate with an electric circuit formed may also be used for the substrate on which the organic EL element is to be mounted.

<Anode>

The organic EL element with a structure in which light is extracted from the light-emitting layer through the anode employs a transparent or semitransparent electrode for the anode. A thin film of a metal oxide, a metal sulphide and a metal, or the like that have high electric conductivity is applicable to the transparent electrode or the semitransparent electrode, and an anode with high light transparency is suitably used. Specifically, a thin film made of, for example, indium oxide, zinc oxide, tin oxide, indium tin oxide (ITO), indium zinc oxide (IZO), gold, platinum, silver, and copper is used, and among them, a thin film made of ITO, IZO, or tin oxide is suitably used. A method for manufacturing the anode may be a vacuum deposition method, a sputtering method, an ion plating method, or a plating method. An organic transparent conductive film such as polyaniline or derivatives thereof and polythiophene or derivatives thereof may also be used for the anode.
A material reflecting light may also be used for the anode. A metal, a metal oxide, and a metal sulphide, all of which have a work function of 3.0 electron volts or larger are preferred for the material.
The film thickness of the anode can be appropriately selected in consideration of light transparency and electric conductivity and is, for example, 10 nanometers to 10 micrometers, preferably, 20 nanometers to 1 micrometer, and more preferably, 50 nanometers to 500 nanometers.

<Hole injection layer>

Hole injection materials constituting the hole injection layer may be an oxide such as vanadium oxide, molybdenum oxide, ruthenium oxide, and aluminum oxide, phenylamine compounds, starburst-type amine compounds, phthalocyanine compounds, amorphous carbon, polyaniline, or polythiophene derivatives.

Examples of a film forming method of the hole injection layer may include a method for forming a film from a solution comprising the hole injection material. The solvent used for forming a film from the solution is not particularly limited so long as the solvent dissolves the hole injection materials. For example, solvents exemplified as solvents used for forming the light-emitting layer and water can be used for the solvent.
A method for forming a film from the solution may be coating methods such as spin coating methods, casting methods, micro-gravure coating methods, gravure coating methods, bar coating methods, roll coating methods, wire bar coating methods, dip coating methods, spray coating methods, screen printing methods, flexo printing methods, offset printing methods, or inkjet printing methods. The film is preferably formed by the coating method of the present invention described as the method for forming the light-emitting layer.
The optimal value for the film thickness of the hole injection layer varies depending on the material used. The film thickness is set as appropriate so as to have moderate values of driving voltage and light-emitting efficiency and needs to be at least a thickness with which no pinhole is formed. When the thickness is too large, the driving voltage of the element increases, which is not preferable. Accordingly, the film thickness of the hole injection layer is, for example, 1 nanometer to 1 micrometer, preferably, 2 nanometers to 500 nanometers, and more preferably, 5 nanometers to 200 nanometers.

<Hole transport layer>

Hole transport materials constituting the hole transport layer may be polyvinyl carbazole or derivatives thereof, polysilane or derivatives thereof, polysiloxane derivatives having an aromatic amine at the side chain or the main chain, pyrazoline derivatives, arylamine derivatives, stilbene derivatives, triphenyldiamine derivatives, polyaniline or.derivatives thereof, polythiophene or derivatives thereof, polyarylamine or derivatives thereof, polypyrrole or derivatives thereof, poly(p-phenylenevinylene) or derivatives thereof, or poly(2,5-thienylenevinylene) or derivatives thereof.
Among them, The hole transport materials may be preferably, polymer hole transport materials such as polyvinyl carbazole or derivatives thereof, polysilane or derivatives thereof, polysiloxane derivatives having an aromatic amine compound group at the side chain or the main chain, polyaniline or derivatives thereof, polythiophene or derivatives thereof, polyarylamine or derivatives thereof, poly(p-phenylenevinylene) or derivatives thereof, or poly(2,5-thienylene vinylene) or derivatives thereof, and further preferably, polyvinyl carbazole or derivatives thereof, polysilane or derivatives thereof, or polysiloxane derivatives having an aromatic amine at the side chain or the main chain. When the hole transport material is a low molecular material, the material is preferably used by being dispersed in a macromolecular binder.
A method for forming a film of the hole transport layer is not particularly limited. The method for forming a film using a low molecular hole transport material may be a method for forming a film from a mixed solution of a macromolecular binder and the hole transport material, and the method for forming a film using a polymer hole transport material may be a method for forming a film from a solution comprising the hole transport material.
A solvent used for forming a film from the solution is not particularly limited so long as the solvent dissolves the hole transport materials. The solvent may be: chlorine solvents such as chloroform, methylene chloride, and dichloroethane; ether solvents such as tetrahydrofuran; aromatic hydrocarbon solvents such as toluene and xylene; ketone solvents such as acetone and methyl ethyl ketone; and ester solvents such as ethyl acetate, butyl acetate, or ethyl cellosolve acetate.
The method for forming a film from the solution may be a coating method similar to the method for forming a film of the hole injection layer described above.
For the polymer binder to be mixed, a binder that does not extremely inhibit charge transportation is preferable, and a binder that has weak absorption of visible light is suitably used. The polymer binder may be polycarbonate, polyacrylate, polymethyl acrylate, polymethyl methacrylate, polystyrene, polyvinyl chloride, or polysiloxane.
The optimal value for the film thickness of the hole transport layer varies depending on the material used. The film thickness is set as appropriate so as to have moderate values of driving voltage and light-emitting efficiency and needs to be at least a thickness with which no pinhole is formed. When the thickness is too large, the driving voltage of the element increases, which is not preferable. Accordingly, the film thickness of the hole transport layer is, for example, 1 nanometer to 1 micrometer, preferably, 2 nanometers to 500 nanometers, and more preferably, 5 nanometers to 200 nanometers.

<Light-emitting layer>

The light-emitting layer is generally made of an organic substance mainly emitting any one of fluorescence and phosphorescence or both, or made of the organic substance and a dopant assisting the organic substance. The dopant is added in order to, for example, improve the light-emitting efficiency and change the emission wavelength. The organic substance may be a low molecular compound or a macromolecular compound. The light-emitting layer preferably comprises a macromolecular compound having a number average molecular weight of $10^3$ to $10^8$ in terms of polystyrene.

Examples of light-emitting materials constituting the light-emitting layer may include the following pigment materials, metal complex materials, polymer materials, and dopant materials.

(Pigment materials)

Examples of the pigment materials may include cyclopendamine derivatives, tetraphenyl butadiene derivative compounds, triphenyl amine derivatives, oxadiazole derivatives, pyrazoloquinoline derivatives, distyrylbenzene derivatives, distyrylarylene derivatives, pyrrole derivatives, thiophene ring compounds, pyridine ring compounds, perynone derivatives, perylene derivatives, oligothiophene derivatives, oxadiazole dimers, pyrazoline dimers, quinacridone derivatives, and coumarin derivatives.

(Metal complex materials)

Examples of the metal complex materials may include metal complexes having as a central metal, Al, Zn, Be, Pt, Ir, a rare-earth metal such as Tb, Eu, and Dy, or the like and having as a ligand, a structure of oxadiazole, thiadiazole, phenylpyridine, phenylbenzimidazole, quinoline, or the like, for example, metal complexes such as iridium complexes and platinum complexes that emit light from the triplet excited state, alumiquinolinol complexes, benzoquinolinole beryllium complexes, benzoxazolyl zinc complexes, benzothiazole zinc complexes, azomethyl zinc complexes, porphyrin zinc complexes, and europium complexes.

(Polymer materials)

The polymer materials may be polyparaphenylene vinylene derivatives, polythiophene derivatives, polyparaphenylene derivatives, polysilane derivatives, polyacetylene derivatives, polyfluorene derivatives, polyvinyl carbazole derivatives, or materials obtained by polymerizing the pigment materials or the metal complex light-emitting materials.
Among the light-emitting materials described above, the materials emitting blue light may be distyrylarylene derivatives, oxadiazole derivatives, and polymers thereof, polyvinyl carbazole derivatives, polyparaphenylene derivatives, or polyfluorene derivatives. Among them, polymer materials such as polyvinyl carbazole derivatives, polyparaphenylene derivatives, and polyfluorene derivatives are preferred.
The materials emitting green light may be quinacridone derivatives, coumarin derivatives, and polymers thereof, polyparaphenylene vinylene derivatives, or polyfluorene derivatives. Among them, polymer materials such as polyparaphenylene vinylene derivatives and polyfluorene derivatives are preferred.
The materials emitting red light may be coumarin derivatives, thiophene ring compounds, and polymers thereof, polyparaphenylene vinylene derivatives, polythiophene derivatives, or polyfluorene derivatives. Among them, polymer materials such as polyparaphenylene vinylene derivatives, polythiophene derivatives, and polyfluorene derivatives are preferred.

(Dopant materials)

Examples of the dopant materials may include perylene derivatives, coumarin derivatives, rubrene derivatives, quinacridone derivatives, squarylium derivatives, porphyrin derivatives, styryl pigments, tetracene derivatives, pyrazolone derivatives, decacyclene, and phenoxazon. The thickness of such a light-emitting layer is generally about 2 nanometers to 200 nanometers.

<Method for forming film of light-emitting layer>

An available method for forming a film of the light-emitting layer may be, besides the methods described above, a vacuum deposition method or a transfer method.
A method for applying the solution comprising the light-emitting material is preferably the coating method of the present invention as described above. Another coating method may be: a coating method such as a spin coating method, a casting method, a micro-gravure coating method, a gravure coating method, a bar coating method, a roll coating method, a wire bar coating method, a dip coating method, a slit coating method, a spray coating method, and a nozzle coating method; and a coating method such as a gravure printing method, a screen printing method, a flexo printing method, an offset printing method, a reverse printing method, or an inkjet printing method.

<Electron transport materials>

Publicly known materials can be used for electron transport materials constituting the electron transport layer.

The materials may be oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or of derivatives thereof, polyquinoline or derivatives thereof, polyquinoxaline or derivatives thereof, or polyfluorene or derivatives thereof.

Among the materials, as the electron transport materials, preferred are oxadiazole derivatives, benzoquinone or derivatives thereof, anthraquinone or derivatives thereof, metal complexes of 8-hydroxyquinoline or of derivatives threof, polyquinoline or derivatives thereof, polyquinoxaline or derivatives thereof, and polyfluorene or derivatives thereof, and more preferred are 2-(4-biphenylyl)-5-(4-t-butylphenyl)-1,3,4-oxadiazole, benzoquinone, anthraquinone, tris(8-quinolinol)aluminum, and polyquinoline.

A method for forming a film of the electron transport layer is not particularly limited. The method for forming a film using a low molecular electron transport material may be a vacuum deposition method using the powder, or a method for forming a film from the solution or from the melted state, and the method for forming a film using a polymer electron transport material may be a method for forming a film from the solution or from the melted state. When a film is formed from the solution or from the melted state, a polymer binder may also be used in combination. Examples of the method for-forming a film of the electron transport layer from the solution may include a film forming method similar to the method for forming a film of the hole injection layer from the solution as described above.

The optimal value for the film thickness of the electron transport layer varies depending on the material used. The film thickness is set as appropriate so as to have moderate values of driving voltage and light-emitting efficiency and needs to be at least a thickness with which no pinhole is formed. When the thickness is too large, the driving voltage of the element increases, which is not preferable. Accordingly, the film thickness of the electron transport layer is, for example, 1 nanometer to 1 micrometer, preferably, 2 nanometers to 500 nanometers, and more preferably, 5 nanometers to 200 nanometers.

<Electron injection layer>

For materials constituting the electron injection layer, optimal materials are appropriately selected depending on the type of the light-emitting layer. The materials may be: an alkali metal; an alkaline-earth metal; alloys comprising one or more types of alkali metals and alkaline-earth metals; an oxide, a halide, and a carbonate of an alkali metal or an alkaline-earth metal; or mixtures of these substances. Examples of the alkali metal, or the oxide, the halide, and the carbonate of the alkali metal may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metal or the oxide, the halide, and the carbonate of the alkaline-earth metal may include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may also be a stacked body in which two or more layers are stacked, and examples thereof may include LiF/Ca. The electron injection layer is formed by a vapor deposition method, a sputtering method, a printing method, or other methods.

The film thickness of the electron injection layer is preferably about 1 nanometer to 1 micrometer.

<Cathode>

Materials that have a small work function, facilitate electron injection into the light-emitting layer, and have high electric conductivity are preferred as materials of the cathode. In the organic EL element in which light is extracted from the anode, materials having high visible light reflectance are preferred as the materials of the cathode because the cathode reflects the light output from the light-emitting layer to the anode.

For example, an alkali metal, an alkaline-earth metal, a transition metal, and a group 13 metal in the periodic table can be used for the cathode. Examples of the materials of the cathode to be used may include: metals such as lithium, sodium, potassium, rubidium, cesium, beryllium, magnesium, calcium, strontium, barium, aluminum, scandium, vanadium, zinc,'yttrium, indium, cerium, samarium, europium, terbium, and ytterbium; alloys of two or more types of the metals; alloys of one or more types of the metals and one or more-types of gold, silver, platinum, copper, manganese, titanium, cobalt, nickel, tungsten, and tin; and graphite or graphite intercalation compounds. Examples of the alloys may include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. A transparent conductive electrode made of a conductive metal oxide, a conductive organic substance, or other substances can be used for the cathode. Specifically, the conductive metal oxide may be indium oxide, zinc oxide, tin oxide, ITO, and IZO. Specifically, the conductive organic substance may be polyaniline or derivatives thereof and polythiophene or derivatives thereof. The cathode may be a stacked body in which two or more layers are stacked. The electron injection layer may also be

used as the cathode.

The film thickness of the cathode is appropriately set in consideration of electric conductivity and durability and is, for example, 10 nanometers to 10 micrometers, preferably, 20 nanometers to 1 micrometer, and more preferably, 50 nanometers to 500 nanometers.

A method for manufacturing the cathode may be a vacuum deposition method, a sputtering method, or a lamination method by which a metal thin film is thermocompression bonded.

<Insulating layer>

Materials of the insulating layer may be a metal fluoride, a metal oxide, or an organic insulating material. The organic EL element comprising the insulating layer having a film thickness of 2 nanometers or smaller may be: an organic EL element comprising the insulating layer having a film thickness of 2 nanometers or smaller that is adjacent to the cathode; or an organic EL element comprising the insulating layer having a film thickness of 2 nanometers or smaller that is adjacent to the anode.

Although the coating method utilizing capillary force and static pressure is described above through the description of the capillary coater system 11, the present invention is not limited to this. The present invention is applicable also to the method of utilizing capillary force, the method of utilizing static pressure, and the method of using'a pump. For example, when the coating liquid is applied utilizing only static pressure without utilizing capillary force, the width of the slit-shape outlets described above may be widened in the shorter-side direction. When a pump is used, the discharged amount of the coating liquid can be controlled without elevating or lowering the tank. The coating liquid may also be applied by the method of utilizing capillary force using a pump. At the non-coating step, the coating liquid is pulled back inside the slit-shape outlets, and the nozzle and the body are spaced by lowering the nozzle. However, the coating liquid may simply be pulled back inside the slit-shape outlets without lowering the nozzle. The coating liquid may also be pulled back inside the slit-shape outlets by lowering the tank to change the static pressure or by power of a pump, and the nozzle and the body may also be relatively moved in the coating direction while the coating liquid is off from the body. Even in this step, the body is not coated with the coating liquid because the coating liquid is off from the body.

The organic EL element as described above can be suitably used for curved or flat lighting devices, planar light sources used for, for example, light sources of scanners and backlights of display devices.

(organic photovoltaic cell)

The coating method of the present invention is suitably applicable not only to the organic EL element but to the manufacture of the organic photovoltaic cell. The organic photovoltaic cell comprises a pair of electrodes of a first electrode and a second electrode and one or more organic layers provided between the electrodes. At least one of the first and the second electrodes is a transparent or semitransparent electrode. The organic photovoltaic cell comprises at least an active layer as the one or more organic layers. This active layer has a function (photovoltaic function) to convert optical energy into electric energy. The layer structures, composition of each layer, and method for manufacturing each layer of organic photovoltaic cell is'described below.

(Active layer)

The active layer constituting a portion of the organic photovoltaic cell of the present invention is provided as an optical active layer converting optical energy into electric energy and functions as a layer originally generating electric power of the organic photovoltaic cell.

One active layer is generally provided in one organic photovoltaic cell. However, two or more light-emitting layers may also be provided in one organic photovoltaic cell in order to achieve high electric power generation efficiency (for example, see Science, 2007, vol. 317, pp. 222 to 225).

The active layer is made of two or more types of semiconductor materials having p-type semiconductor properties and n-type semiconductor properties. At least one of the two or more types of semiconductor materials is an organic substance. The active layer is constituted of (I) a stacked body formed by stacking a layer made of a p-type semiconductor material and a layer made of an n-type semiconductor material, or (II) a mixed layer in which the p-type semiconductor material and the n-type semiconductor material are integrally mixed. The active layer is preferably constituted of the mixed layer. This is because the optical charge separation interface between the p-type semiconductor material and the n-type semiconductor material can be widely formed in the mixed layer.

Although the organic substances having the semiconductor properties described above may be low molecular compounds or macromolecular compounds, macromolecular compounds are preferable from the viewpoint of solubility in solvents and preferably have a number average molecular weight of $10^3$ to $10^8$ in terms of polystyrene.

Conjugated polymer compounds are preferable as the polymer compound having the p-type semiconductor

property. This is because the conjugated polymer compounds have high hole conductivity. The conjugated polymer compounds mean (1) polymer compounds substantially have a structure in which a double bond and a single bond are alternately arranged, (2) polymer compounds substantially have a structure in which a double bond and a single bond are arranged via a nitrogen atom, (3) polymer compounds substantially have a structure in which a double bond and a single bond are alternately arranged and a structure in which a double bond and a single bond are arranged via a nitrogen atom, and the like. Specifically, examples of the conjugated polymer compounds may include polymer compounds in which one or more types of diyl groups are used as repeating units that are selected from the group consisting of an unsubstituted or substituted fluorenediyl group, an unsubstituted or substituted benzofluorenediyl group, an unsubstituted or substituted dibenzofurandiyl group, an unsubstituted or substituted dibenzothiophenediyl group, an unsubstituted or substituted carbazolediyl group, an unsubstituted or substituted thiophenediyl group, an unsubstituted or substituted furandiyl group, an unsubstituted or substituted pyrrolediyl group, an unsubstituted or substituted benzothiadiazolediyl group, an unsubstituted or substituted phenylenevinylenediyl group, an unsubstituted or substituted thienylenevinylenediyl group, and an unsubstituted or substituted triphonyldminediyl group, and in which the repeating units are bonded together directly or via a linking group. The conjugated polymer compounds preferably, have thiophene ring structures and more preferably, have, as repeating units, thiophenediyl groups in view of a charge transport property.

Examples of materials having the n-type semiconductor property may include the conjugated polymer compounds described above, organic low molecular compounds, fullerene derivatives, and inorganic substances that are described below.

The organic low molecular compounds may be oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, 8-hydroxyquinoline, or metal complexes of derivatives of 8-hydroxyquinoline, polyquinoline or derivatives thereof, polyquinoxaline or derivatives thereof, or polyfluorene or derivatives thereof.

The fullerene derivatives may be derivatives of C60, C70, or C84.

The derivatives of C60 may be the following derivatives.

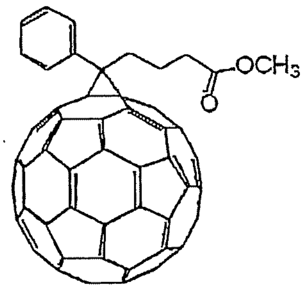

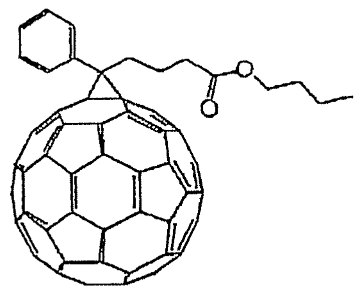

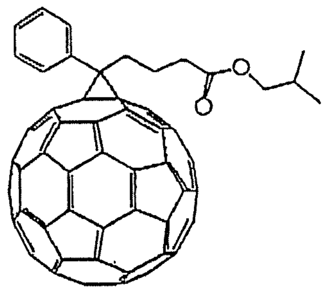

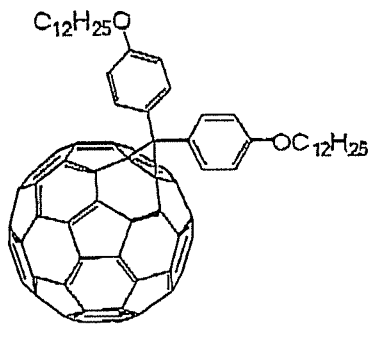

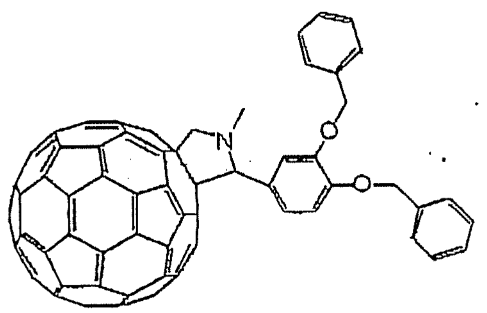

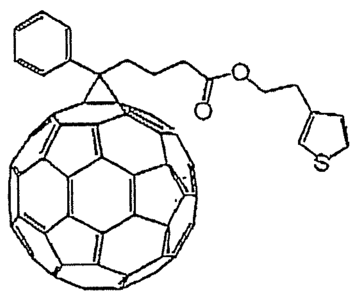 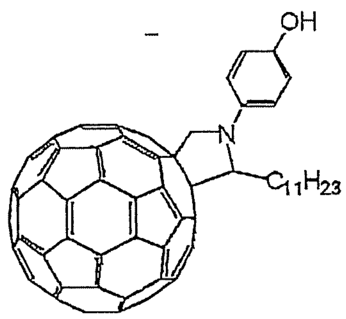

The derivatives of C70 may be the following derivatives.

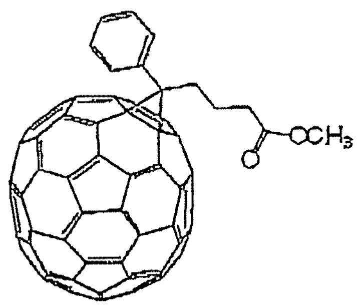 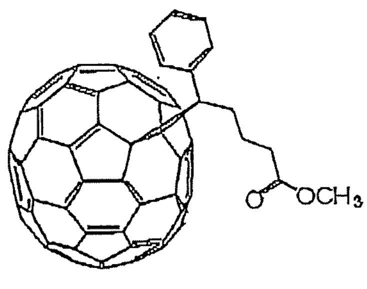 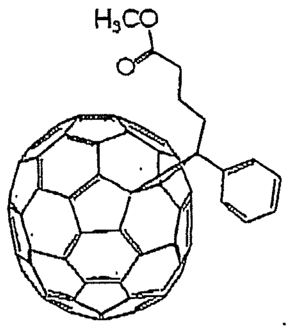

The inorganic substances may be compound semiconductors such as CdSe or oxide semiconductors such as titanium oxide, zinc oxide, tin oxide, and niobium oxide.

(First and second electrodes)

A transparent or semitransparent electrode is used for at least one of the first and the second electrodes. A thin film of a metal oxide, a metal sulphide, a metal, or the like that have high electric conductivity is applicable to the transparent electrode or the semitransparent electrode, and an electrode with high light transparency is suitably used.

Specifically, a thin film made of, for example, indium oxide, zinc oxide, tin oxide, ITO, IZO, gold, platinum, silver, and copper is used, and among them, a thin film made of ITO, IZO, or tin oxide is suitably used. A method for manufacturing the transparent electrode or the semitransparent electrode may be a vacuum deposition method, a sputtering method, an ion plating method, or a plating method. A transparent conductive film of an organic substance such as polyaniline or derivatives thereof and polythiophene or derivatives thereof may also be used for the transparent electrode or the semitransparent electrode.

The transparent electrode or the semitransparent electrode described above or an electrode reflecting light is used for an electrode arranged so as to oppose to the transparent or the semitransparent electrode described above. Electrode materials of such an electrode are preferably a metal, a metal oxide, and metal sulphide, all of which have a work function of 3.0 electron volts or larger.

The organic photovoltaic cell comprises a prescribed intermediate layer between the electrode and the active layer, if necessary. The intermediate layer is provided for, for example, enhancing electric power generation property and process durability. That is, the intermediate layer is provided as needed that has properties of selectively extracting electrons or holes, a property of lowering an energy barrier between the electrode and the active layer, a property of reducing damage to a film-forming property during the formation of a film comprised in the stacked body and to the under layer of this film, or other properties. Such an intermediate layer is provided at any one of a portion between the first electrode and the active layer, and a portion between the active layer and the second electrode, or both. The intermediate layer having a property of selectively extracting holes may be a layer comprising poly(ethylenedioxythiophene) (PEDOT). The intermediate layer having a property of selectively extracting electrons may be a layer comprising titanium oxide, zinc oxide, or tin' oxide.

The organic photovoltaic cell is manufactured by sequentially stacking the first electrode, at least one intermediate layer provided if necessary, the active layer, one or more intermediate layers provided if necessary, and the second electrode on a substrate in this order. A method for manufacturing the organic photovoltaic cell of the present invention

comprises a step of forming an organic layer by coating a body in a pattern with a coating liquid comprising an organic material by the coating method of the present invention as described above and by drying it. In such a manner, the organic layer is formed by the coating method described above to allow pattern formation of a plurality of organic photovoltaic cells.

When multiple organic layers out of the organic layers provided between the first and the second electrodes can be formed by a coating method, it is preferable that all of the organic layers be formed by the coating method of the present invention. However, for example, at least one layer out of the multiple organic layers capable of being formed by a coating method may also be formed by the coating method of the present invention as described above, and the other organic layers may also be formed by a method different from the coating method of the present invention. The intermediate layer and/or the active layer may also be formed by, besides the coating method of the present invention, a coating method such as a spin coating method, a casting method, a micro-gravure coating method, a gravure coating method, a bar coating method, a roll coating method, a wire bar coating method, a dip coating method, a slit coating method, a spray coating method, a nozzle coating method, a gravure printing method, a screen printing method, a flexo printing method, an offset printing method, a reverse printing method, and an inkjet printing method; a gas phase method such as a vapor deposition method, a sputtering method, and a laser ablation method; and a sol-gel method.

The organic photovoltaic cell of the present invention is irradiated with light such as sunlight from the transparent or the semitransparent electrode to generate photovoltaic power between the electrodes and therefore can be operated as an organic thin film solar cell. A solar photovoltaic module can be created by forming a plurality of organic thin film solar cells in a pattern by the coating method of the present invention in a manner as described above and by integrating them.

The organic photovoltaic cell of the present invention is irradiated with light from the transparent or the semitransparent electrode while voltage is applied to a portion between the electrodes to flow photoelectric current and therefore can be operated as an organic optical sensor.

Examples

(Example 1)

3x2 (six) organic EL elements arrayed in three rows in the coating direction X and in two columns in the width direction Y were manufactured on a glass substrate. The dimension of each of the organic EL elements was 300 mmx44 mm. That is, the width of each organic EL element in the row direction (width direction Y) was 30 millimeters and the width in the column direction (coating direction X) was 44 millimeters. The interval between the organic EL elements in the row direction (width direction Y) was 10 millimeters and the interval between the organic EL elements in the column direction (coating direction X) was 13 millimeters. The structure of each organic EL element is as described below.

"Glass substrate/anode (ITO)/hole injection layer (PEDOT)/light-emitting layer /electron injection layer (BaO)/cathode (Al)"

A substrate was prepared on which an ITO thin film having a film thickness of 150 nanometers was previously formed in a pattern. A suspension of poly(3,4)ethylenedioxythiophene/polystyrene sulfonate (Baytron P, manufactured by H.C. Starck GmbH) was applied onto this substrate by a spin coating method to form a coating film having a thickness of 65 nanometers. The coating liquid applied at an undesired portion was wiped off. Subsequently, the substrate was dried on a hot plate at 200 degrees Celsius for 10 minutes to produce a hole injection layer.

A light-emitting material (Lumation GP1300, manufactured by Sumation Co Ltd.) was dissolved in a solvent of xylene:cyclohexylbenzene (CHB)=8:2 (weight ratio) to prepare a coating liquid for a light-emitting layer. The ratio of the light-emitting material to the coating liquid was 1.3% by weight.

The coating liquid for a light-emitting layer was applied in a pattern by using a capillary coating system (machine name: CAP Coater III, manufactured by HIRANO TECSEED Co., Ltd) as illustrated in Fig. 1. The nozzle having two slit-shape outlets was used. The width of each of the slit-shape outlets in the longitudinal direction (width direction Y) was 30 millimeters and the width in the shorter-side direction (coating direction X) was 0.3 millimeter. The interval between the two slit-shape outlets was 10 millimeters. A coating step and a non-coating step were alternately repeated using such a nozzle to form coating films for light-emitting layers arrayed in three rows and in two columns at prescribed intervals. Moreover, the films were baked under nitrogen atmosphere to form light-emitting layers having a film thickness of 100 nanometers.

Subsequently, BaO layers having a film thickness of 1.2 nanometers and further Al layers having a film thickness of 100 nanometers were formed by electron beam deposition to manufacture six organic EL elements.

Light emission of all of the organic EL elements was confirmed by applying a voltage to these six organic EL elements.

(Example 2)

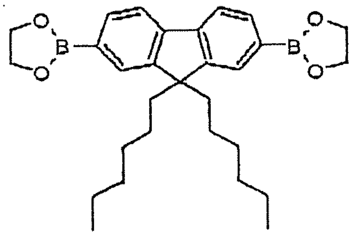

(A)

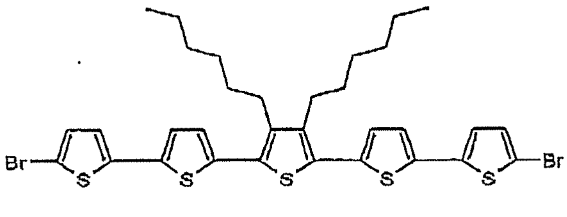

(B)

(SYNTHESIS OF POLYMER A)

A compound (A) (7.928 grams, 16.72 millimoles), a compound (B) (13.00 grams, 17.60 millimoles), methyltrioctylammonium chloride (trade name: aliquat 336, manufactured by Aldrich Co., CH3N[(CH2)7CH3]3Cl, density: 0.884 g/ml at 25 degrees Celsius, a trademark of Henkel Corporation) (4.979 grams), and 405 milliliters of toluene were charged into a 2L four-neck-flask inside of which was replaced with argon. The inside of the system was bubbled with argon while stirring for 30 minutes.

Dichlorobis(triphenylphosphine)palladium (II) (0.02 grams) was added to the system, and 42.2 milliliters of a 2 mol/L sodium carbonate aqueous solution was added dropwise to the system while elevating the temperature to 105 degrees Celsius and stirring it. The reaction was kept for 5 hours after the.dropwise addition, phenylboronic acid (2.6 grams) and 1.8 milliliters of toluene were added to the system, and the mixture was stirred at 105 degrees Celsius for 16 hours. Subsequently, 700 milliliters of toluene and 200 milliliters of a 7.5% sodium diethyldithiocarbamate trihydrate aqueous solution were added to the system, and the mixture was stirred at 85 degrees Celsius for 3 hours. After the water phase of the reaction liquid was removed, the organic phase was washed with 300 milliliters of ion-exchange water at 60 degrees Celsius twice, 300 milliliters of 3% acetic acid at 60 degrees Celsius once, and further 300 milliliters of ion-exchange water at 60 degrees Celsius three times. The organic phase was passed through a column filled with Celite, alumina, and silica, and the column was washed with 800 milliliters of hot toluene. The solution was concentrated to 700 milliliters and then was poured into 2 litters of methanol to be reprecipitated. The polymer was filtered to be recovered and then was washed with 500 milliliters of methanol, 500 milliliters of acetone, and 500 milliliters of methanol. The polymer was dried at 50 degrees Celsius under a vacuum overnight to produce 12.21 grams of a pentathienylfluorene copolymer (hereinafter, referred to as a "polymer A") of a formula:

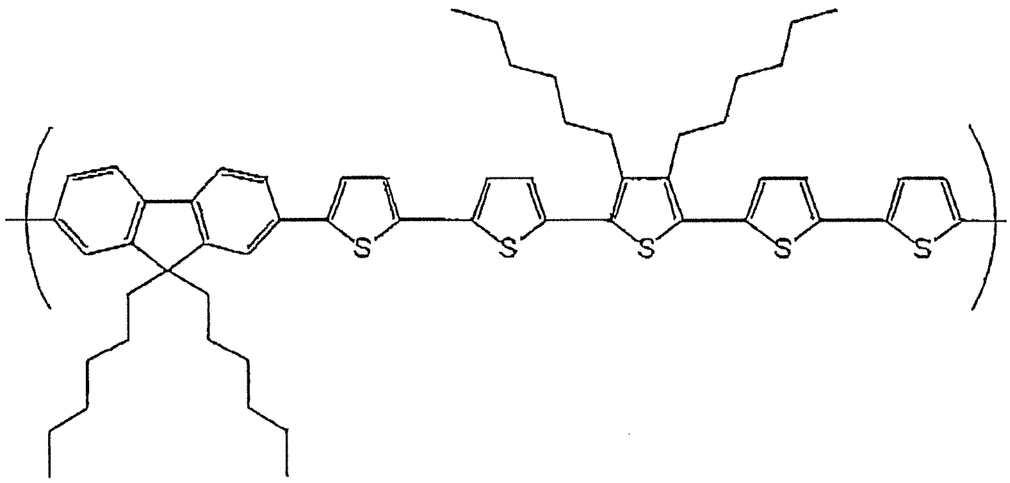

The polymer A had a number average molecular weight of $5.4\times10^4$ and a weight average molecular weight of $1.1\times10^5$ in terms of polystyrene.

(Manufacture of organic photovoltaic cell)

3x2 (six) organic photovoltaic cell arrayed in three rows in the coating direction X and in two columns in the width direction Y were manufactured on a substrate. The dimension of each of the organic photovoltaic cells was 30 mmx44 mm. That is, the width of each organic photovoltaic cell in the row direction (width direction Y) was 30 millimeters and the width in the column direction (coating direction X) was 44 millimeters. The interval between the organic photovoltaic cells in the row direction (width direction Y) was 10 millimeters and the interval between the organic photovoltaic cells in the column direction (coating direction X) was 13 millimeters.
The structure of each organic photovoltaic cell is as described below.

"Glass substrate/ITO/PEDOT layer/active layer /BaO/Al"

A substrate was prepared on which an ITO thin film having a film thickness of 150 nanometers was previously formed in a pattern. A suspension of poly(3,4)ethylenedioxythiophene/polystyrene sulfonate (Baytron P, manufactured by H.C. Starck GmbH) was applied onto this substrate by a spin coating method to form a coating film having a thickness of 65 nanometers. The coating liquid applied at an undesired portion was wiped off. Subsequently, the substrate was dried on a hot plate at 200 degrees Celsius for 10 minutes to produce a PEDOT layer.
The polymer A corresponding to the p-type semiconductor material and PCBM (trade name: E100, lot. 7B0168-A, manufactured by Frontier Carbon Corporation) corresponding to the n-type semiconductor material were added to an orthodichlorobenzene solvent (polymer A: 0.5% by weight, PCBM: 1.5% by weight). The mixture was stirred at 70 degrees Celsius for 2 hours and then was filtered using a filter having a pore diameter of 0.2 micrometer to prepare a coating liquid for an active layer.
The coating liquid for an active layer was applied in a manner similar to the method for applying the coating liquid for a light-emitting layer in Example 1 to form coating films for active layers arrayed in three rows and in two columns at prescribed intervals. The obtained active layers have a film thickness of 100 nanometers.
Subsequently, BaO layers having a film thickness of 1.2 nanometers and further Al layers having a film thickness of 100 nanometers were formed by electron beam deposition to manufacture six organic photovoltaic cells.
Photoelectric conversion of the obtained six organic photovoltaic cells was measured using a solar simulator (trade name: YSS-80, manufactured by Yamashita Denso Corporation). Currents and voltages that are obtained by irradiating the organic photovoltaic cells with light that had passed an AM1.5G filter and that had an irradiance of 100 mW/cm$^2$ were measured, and as a result, electric power generation of all of the organic photovoltaic cells was confirmed.

## INDUSTRIAL APPLICABILITY

According to the present invention, the coating liquid can be applied using the nozzle having a plurality of slit-shape outlets discharging the coating liquid, and therefore, a plurality of coating films in stripe shapes can be formed that are applied at prescribed intervals in a direction perpendicular to the coating direction. Moreover, the coating step and the non-coating step are repeated in the coating direction using such a nozzle to allow pattern coating also in the coating direction. In such a manner, pattern coating is performed both in the direction perpendicular to the coating direction and in the coating direction, and as a result, two-dimensional pattern coating can be performed. Thus, pattern coating can be performed in a large area without coating an undesired portion with the coating liquid, and a step of removing the coating liquid applied to the undesired portion can be omitted.

## Claims

1. A method for coating a body with a coating liquid, the body being arranged above a nozzle through which the coating liquid is to be discharged upwardly, the coating method comprising:

    a coating step in which the nozzle and the body are relatively moved in a prescribed coating direction while the body is kept in contact with the coating liquid discharged through the nozzle; and
    a non-coating step in which the nozzle and the body are relatively moved to the coating direction while the body is kept detached the coating liquid, wherein
    the two steps of coating and non-coating are alternately repeated, using the nozzle, which has a plurality of slit-shape outlets.

2. The method according to claim 1, wherein the nozzle comprises a shim specifying the width of the slit-shape outlets in the shorter-side direction of the outlets, and
the shim is provided in a region except the slit-shape outlets and has a non-liquid feeding portion.

3. A method for manufacturing an organic electroluminescent element comprising one or more organic layers, the method comprising: coating a body in a pattern with a coating liquid comprising an organic material by the coating method according to claim 1 or 2 and drying the liquid to form the one or more organic layers.

4. A lighting device comprising an organic electroluminescent element manufactured by the manufacturing method according to claim 3.

5. A planar light source comprising an organic electroluminescent element manufactured by the manufacturing method according to claim 3.

6. A method for manufacturing an organic photovoltaic cell comprising one or more organic layers, the method comprising: coating a body in a pattern with a coating liquid comprising an organic material by the coating method according to claim 1 or 2, and drying the liquid to form the one or more organic layers.

7. A solar photovoltaic module comprising an organic photovoltaic cell manufactured by the manufacturing method according to claim 6.

8. An organic optical sensor comprising an organic photovoltaic cell manufactured by the manufacturing method according to claim 6.

FIG.1

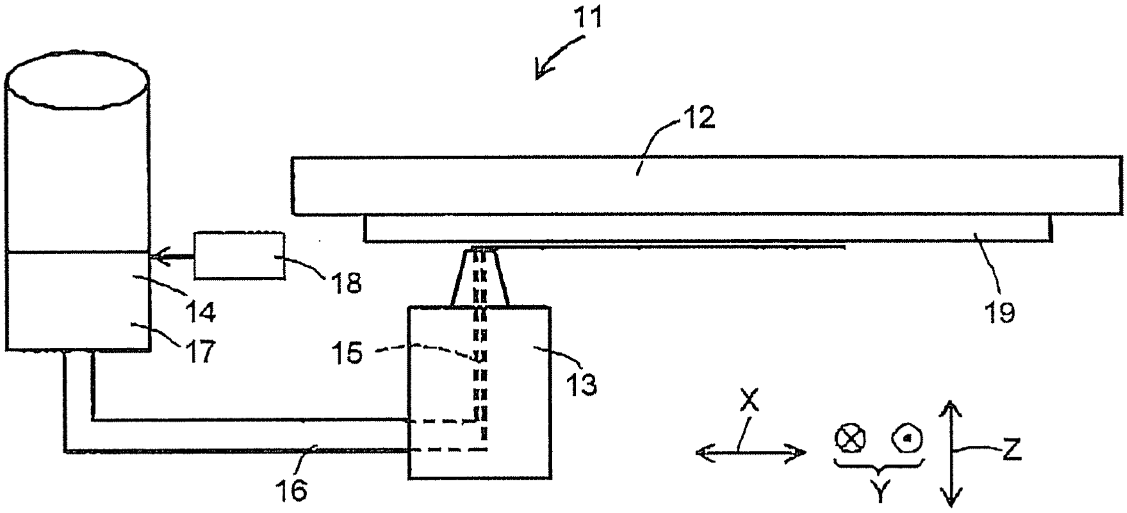


FIG.2

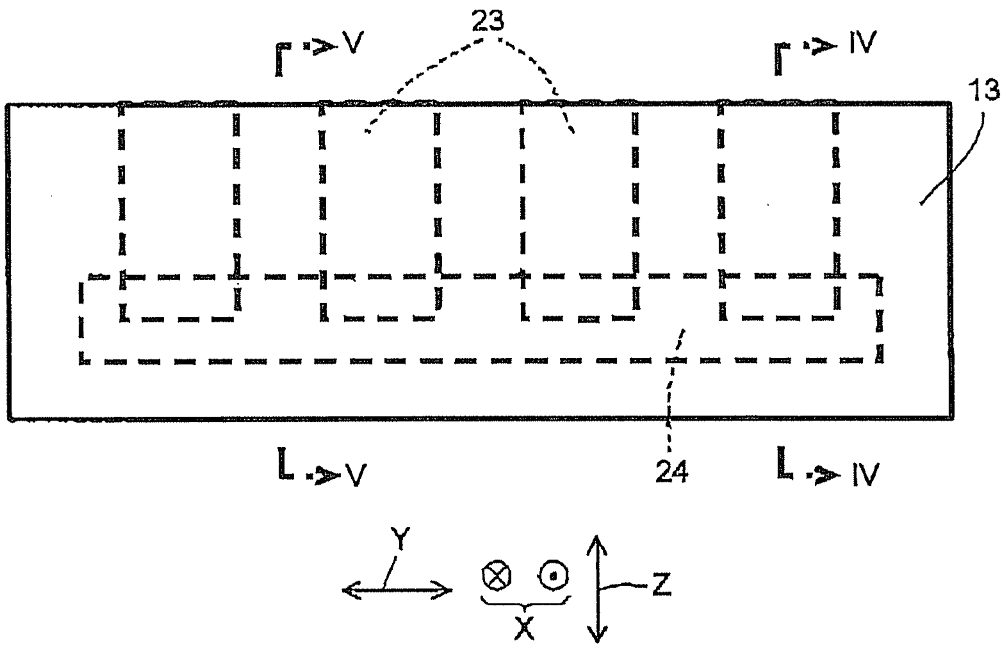

FIG.3

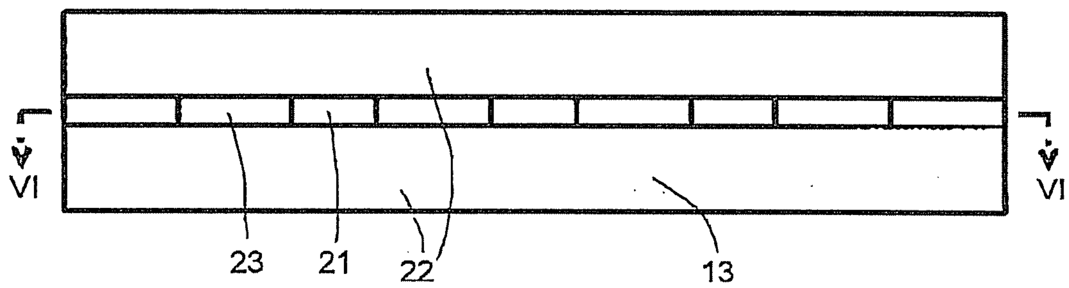


FIG.4

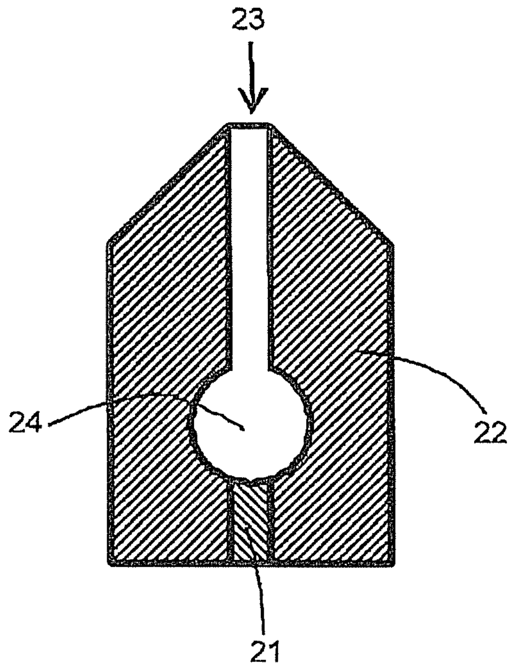

FIG.5

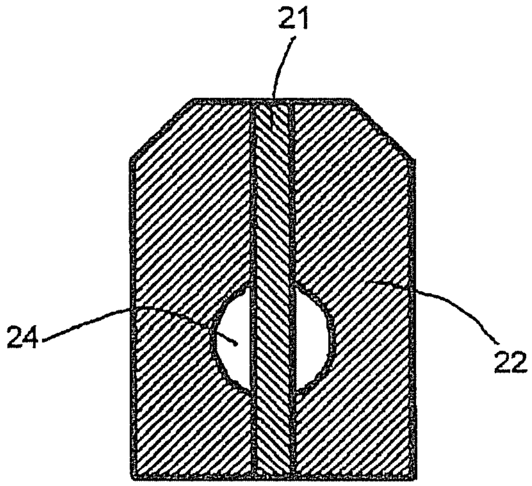


FIG.6

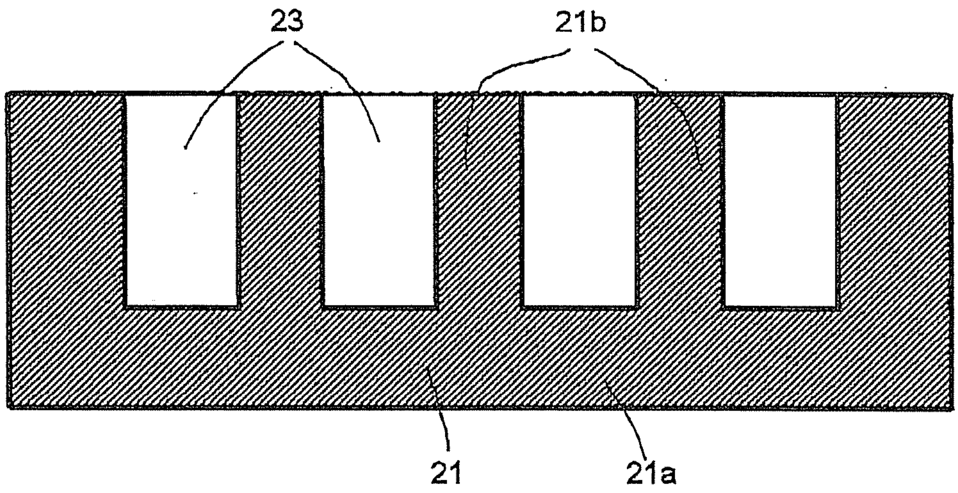

FIG.7

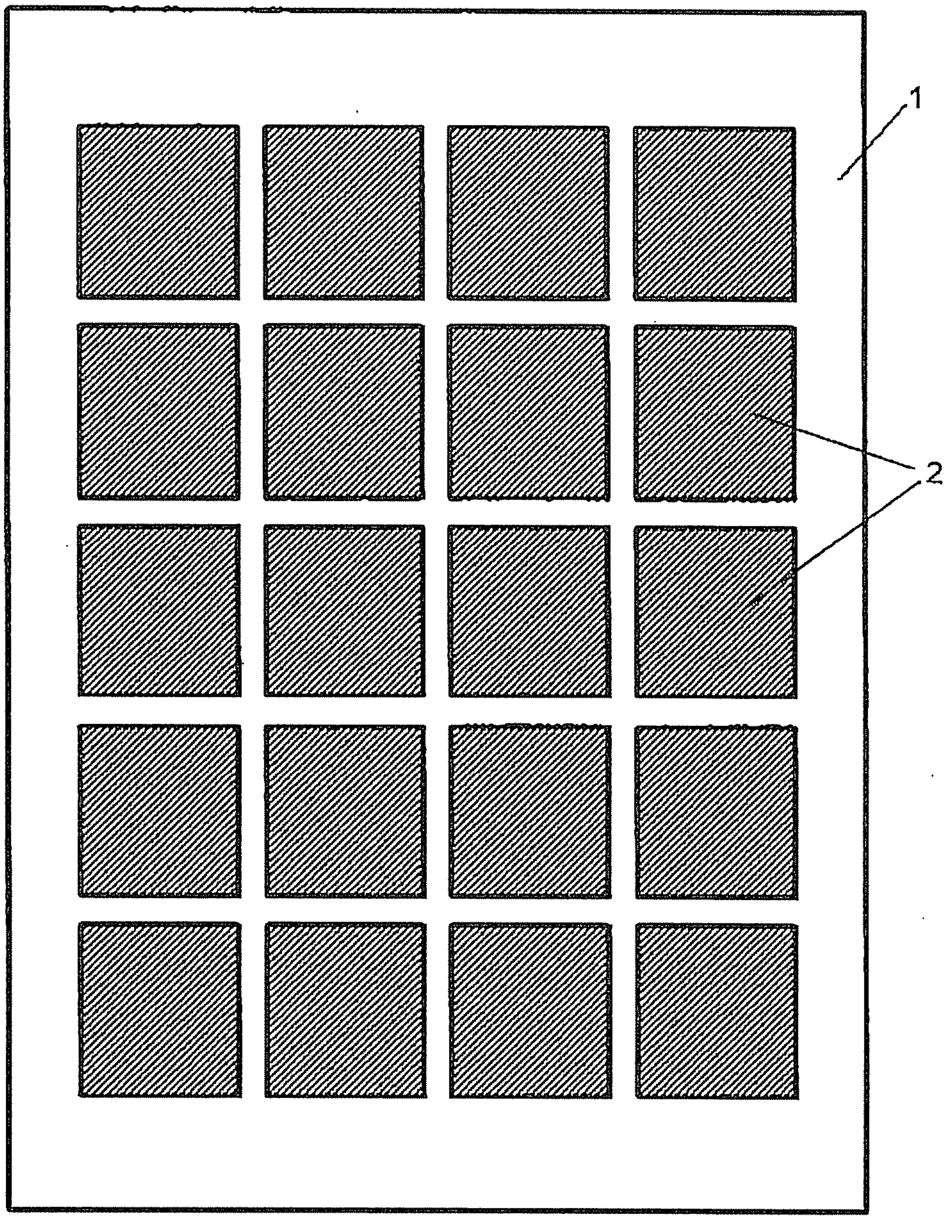

**INTERNATIONAL SEARCH REPORT**

International application No.
PCT/JP2010/055779

A. CLASSIFICATION OF SUBJECT MATTER
*B05D1/26*(2006.01)i, *H01L51/50*(2006.01)i, *H05B33/10*(2006.01)i

According to International Patent Classification (IPC) or to both national classification and IPC

B. FIELDS SEARCHED

Minimum documentation searched (classification system followed by classification symbols)
B05D1/26, H01L51/50, H05B33/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2001-113214 A (Casio Computer Co., Ltd.),<br>24 April 2001 (24.04.2001),<br>entire text<br>(Family: none) | 1,3-5<br>2,6-8 |
| Y | JP 11-314061 A (Toray Industries, Inc.),<br>16 November 1999 (16.11.1999),<br>entire text<br>(Family: none) | 2 |
| Y | JP 2009-60053 A (Fujifilm Corp.),<br>19 March 2009 (19.03.2009),<br>entire text<br>(Family: none) | 6-8 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 28 June, 2010 (28.06.10) | 06 July, 2010 (06.07.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004164873 A


### Non-patent literature cited in the description


- *Science,* 2007, vol. 317, 222-225